(19) Europäisches Patentamt
European Patent Office
Office européen des brevets

(11) EP 0 465 170 B1

(12) # EUROPEAN PATENT SPECIFICATION

(45) Date of publication and mention
of the grant of the patent:
**08.01.1997 Bulletin 1997/02**

(51) Int Cl.6: **H01L 27/11**

(21) Application number: **91305906.9**

(22) Date of filing: **28.06.1991**

(54) **Static RAM cell**

Statische RAM-Zelle

Cellule de RAM statique

(84) Designated Contracting States:
**DE GB IT NL**

(30) Priority: **29.06.1990 JP 173805/90**

(43) Date of publication of application:
**08.01.1992 Bulletin 1992/02**

(73) Proprietor: **SHARP KABUSHIKI KAISHA
Osaka 545 (JP)**

(72) Inventor: **Adan, Alberto Oscar
Tenri-shi, Nara-ken (JP)**

(74) Representative: **Brown, Kenneth Richard et al
R.G.C. Jenkins & Co.
26 Caxton Street
London SW1H 0RJ (GB)**

(56) References cited:
EP-A- 0 029 099          EP-A- 0 365 690
EP-A- 0 420 646          GB-A- 2 141 871
US-A- 4 984 200

- PATENT ABSTRACTS OF JAPAN vol. 13, no. 404 (E-817)7 September 1989 &JP - A - 1 144 655.
- PATENT ABSTRACTS OF JAPAN vol. 13, no. 404 (E-817)7 September 1989 &JP - A - 1 144 674.
- PATENT ABSTRACTS OF JAPAN vol. 13, no. 433 (E-824)27 September 1989 &JP - A - 1 161 860.
- INTERNATIONAL ELECTRON DEVICES MEETING December 1988, SAN FRANCISCO, CA, USA pages 48 - 51; T. YAMANAKA ET AL.: 'A 25 UM2 NEW POLY-SI PMOS LOAD (PPL) SRAM CELL HAVING EXCELLENT SOFT ERROR IMMUNITY'

**Description**

BACKGROUND OF THE INVENTION

1. Field of the Invention

The present invention relates to a static RAM cell, and more particularly to a structure in which loads are connected with transistors forming a flip-flop as a storage element.

2. Description of the Prior Art

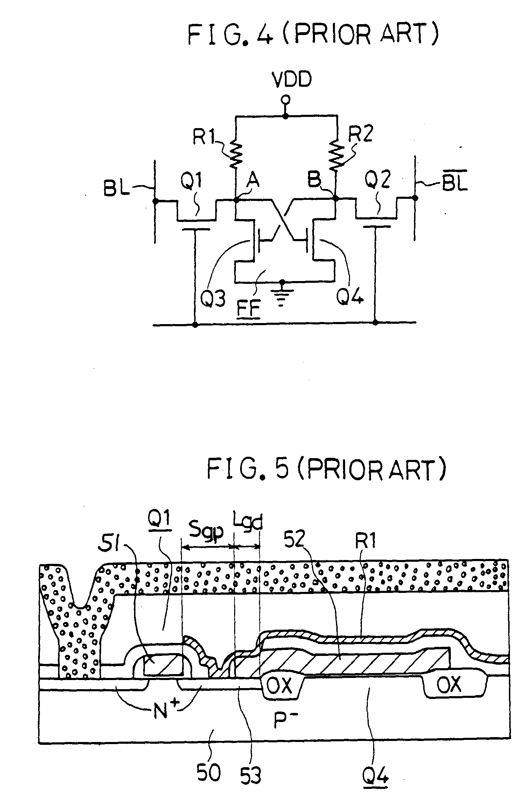

Referring to a conventional static RAM cell, a storage element is a flip-flop which is formed by two cross-connected inverters. It is necessary to greatly reduce a cell size of the storage element in the high density static RAM cell. Figs. 4 and 5 show an electric circuit and a structure of the conventional high density static RAM cell which is manufactured by a MOS technology.

The static RAM cell comprises four N-channel bulk transistors and two high value polysilicon resistances. In Figs. 4 and 5, access transistors Q1 and Q2 connect nodes A and B of a storage element cell with bit lines BL and $\overline{BL}$, respectively.

A flip-flop FF includes transistors Q3 and Q4, and load resistances R1 and R2. The transistors Q1, Q2, Q3 and Q4 are formed as bulk elements on a semiconductor substrate by the MOS technology. To save space and make density high, the load resistances R1 and R2 are formed on a polysilicon layer which is deposited on the bulk elements.

As shown in Fig. 5, a P⁻-type silicon substrate is indicated at 50, an element isolation region is indicated at OX, a polysilicon gate electrode of the access transistor Q1 is indicated at 51, a polysilicon gate electrode of the transistor Q4 is indicated at 52, and a drain region of the transistor Q1 is indicated at 53.

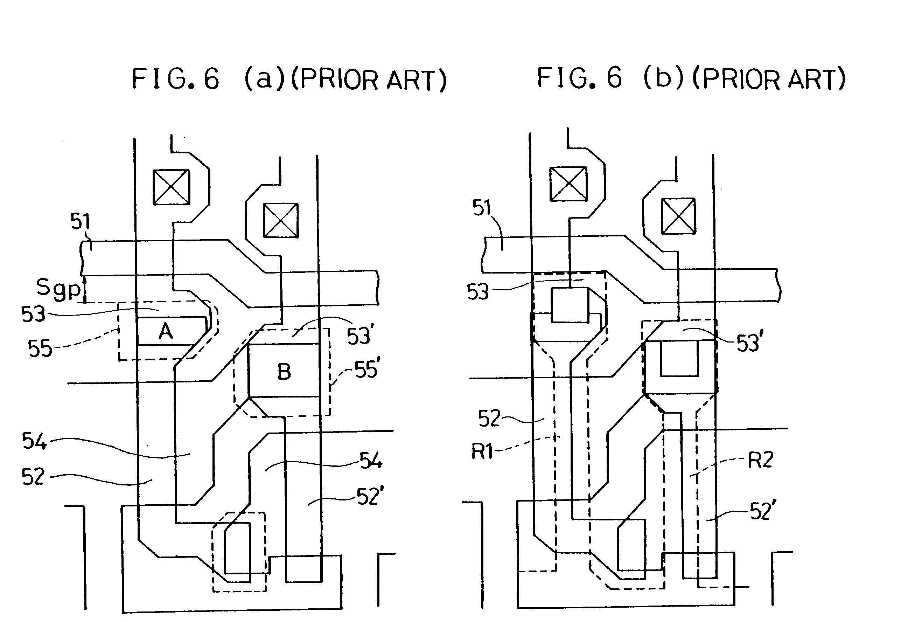

Fig. 6 is a plan view showing the typical arrangement of a memory cell having the above-mentioned structure.

As shown in Fig. 6 (a), an active region 54 is formed, and a first polysilicon layer is then deposited and patterned. Consequently, the gates 51, 52 and 52′ are formed. Prior to the deposition of the first polysilicon layer, connection windows 55 and 55′ are provided on a gate oxide film of the drain regions 53 and 53′. Thus, the so-called buried connection can be obtained. Accordingly, the gate electrodes 52 and 52′ are respectively extended over the drain regions of the N-channel bulk transistors Q1 and Q2 beyond the element isolation region OX by patterning the first polysilicon layer. Consequently, the gate electrodes 52 and 52' are directly connected with the drain regions 53 and 53'.

As shown in Fig. 6(b), a second polysilicon layer is deposited on the gate electrodes 52 and 52' through an insulating film and is then patterned, so that the load resistances R1 and R2 are formed.

With the above-mentioned structure, the cell size is increased for the following reasons.

1. The buried connnection is formed by the first polysilicon layer. Consequently there is a minimum spacing, designated as Sgp in Fig. 5 and Fig. 6(a), determined by photoetching resolution.
2. The buried connection needs a minimum overlap of the first polysilicon gate electrode to the drain regions, indicated as Lgd in Fig. 5.
The foregoing occurs depending on accuracy in a photolithographic process.
3. To obtain the buried connection the connection windows are provided on the gate oxide film before the polysilicon is deposited. As a result, the gate oxide film is deteriorated.

JP-A-1-144674 discloses a memory cell in which, in order to improve the degree of integration, one end of a conductive layer is connected to the semiconductor region of a MISFET for transfer and the other end thereof is connected to the top face of a gate electrode of a MISFET for drive.

SUMMARY OF THE INVENTION

It is an object of the present invention to reduce the cell size of a static RAM cell.

In one aspect, the present invention provides the method of fabricating a static RAM cell defined by claim 1.

In another aspect, the present invention provides the static RAM cell defined by claim 2.

The sub-claims 3 to 6 are directed to embodiments of the invention.

According to the invention, the gate electrode connections of bulk transistors forming a flip-flop as storage element are self-aligned with the drain or source regions of cross-connected bulk transistors in place of buried connections so that a cell size can be reduced.

BRIEF DESCRIPTION OF THE DRAWINGS

Figure 1 is a longitudinal section view of a main portion according to an embodiment of the present invention;
Figures 2(a) to (d) are plan views showing the schematic pattern structure at the time of cell formation;
Figure 3(a) to (g) are views showing manufacturing steps according to the embodiment of the present invention;
Figure 4 is an equivalent electric circuit diagram according to the prior art;
Figure 5 is a longitudinal section view showing a main portion of the structure according to the prior art; and
Figures 6(a) and (b) are plan views showing the schematic pattern structure at the time of cell formation according to the prior art.

DETAILED DESCRIPTION OF A PREFERRED EMBODIMENT

A preferred embodiment of the present invention will be described in detail with reference to the drawings. The present invention is not limited to the following embodiment.

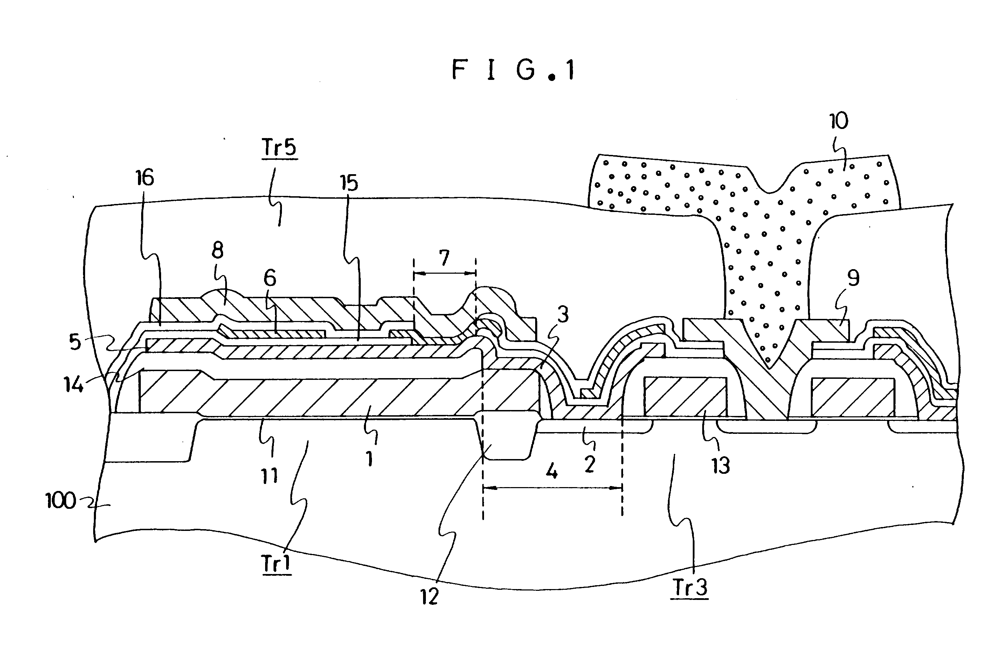

Fig. 1 is a longitudinal section view of a static RAM cell showing the structure of a first conductive strap layer 3, and first and third N-channel bulk transistors Tr1 and Tr3 which are formed on a semiconductor substrate 100. The first and third bulk transistors Tr1 and Tr3 and the first conductive strap layer 3 can be replaced by second and fourth bulk transistors Tr2 and Tr4 and a second conductive strap layer 3', respectively. Accordingly, there is not shown the structure of the second and fourth bulk transistors Tr2 and Tr4 and the second conductive strap layer 3'.

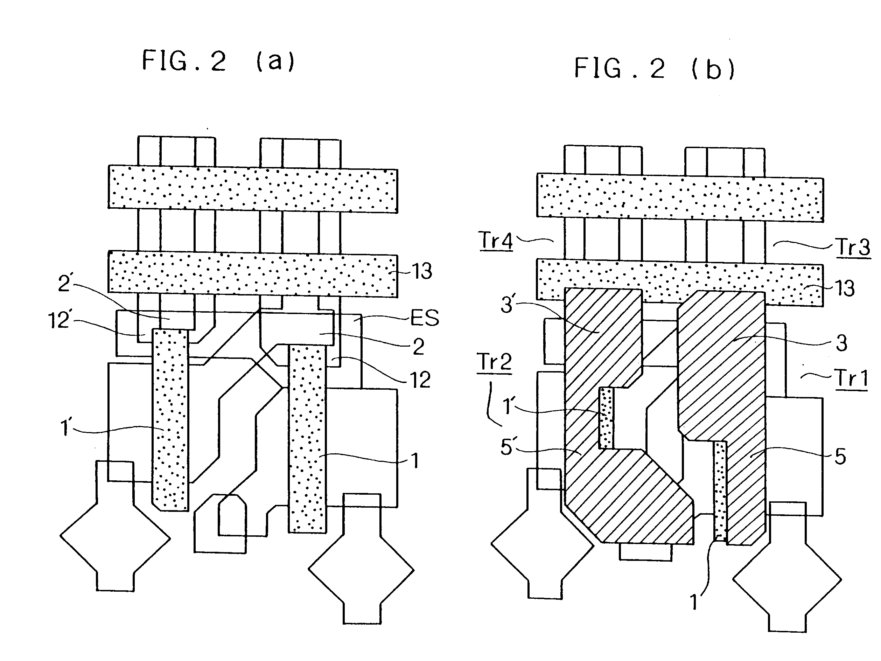

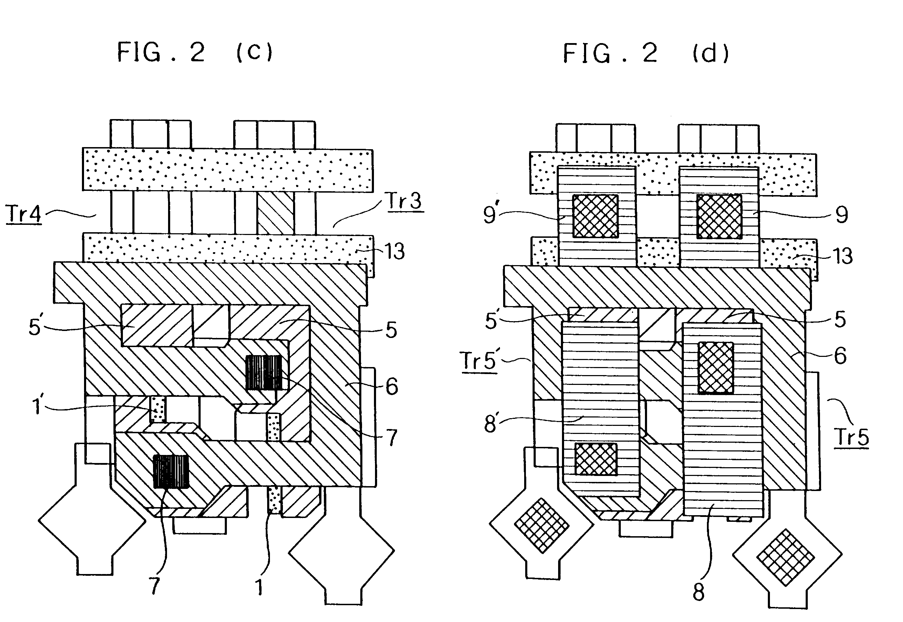

Figs. 2 (a) to (d) are plan views showing the schematic structure at the time of cell formation.

The first and second bulk transistors Tr1 and Tr2 conventionally form a flip-flop.

Referring to Figs. 1 and 2, a gate electrode of the first bulk transistor Tr1 is indicated at 1. The gate electrode 1 is formed by depositing polysilicon on a gate oxide film 11 provided on the semiconductor substrate 100 and then patterning the same. Indicated at 12 is an element isolation region over which the gate electrode 1 is extended.

Formed adjacently to the element isolation region 12 is a drain region 2 which is a diffusion region of the third bulk transistor Tr3. A gate electrode of the third bulk transistor Tr3 is indicated at 13.

The first conductive strap layer is indicated at 3. The first conductive strap layer 3 is formed on the gate electrode 1 through an opening in the insulating film 14, and on the drain region 2. The insulating film 14 is not formed in a shoulder portion of the gate electrode 1 on the element isolation region 12. Consequently, the gate electrode 1 is self-aligned with the drain region 2 through the first conductive strap layer 3. In this case, a strap connection area is indicated at 4. The first conductive strap layer 3 functions as a lower gate electrode 5 of a PMOS thin film transistor Tr5. The PMOS thin film transistor Tr5 is a load of the flip-flop to be described below.

The thin film transistor Tr5 includes the lower gate electrode 5, a thin film transistor body 6, a connection pad 7 for stacked connection and an upper gate electrode 8. The thin film transistor body 6 is formed above the lower gate electrode 5 through an insulating film 15. The connection pad 7 is connected with the lower gate electrode 5 through an opening provided on the insulating film 15. The upper gate electrode 8 is insulated from the thin film transistor body 6 through an insulating film 16 and is connected with the connection pad 7.

A connection pad for a metallic wire 10 is indicated at 9. The connection pad 9 is formed so as to be connected with a source region of the third bulk transistor Tr3.

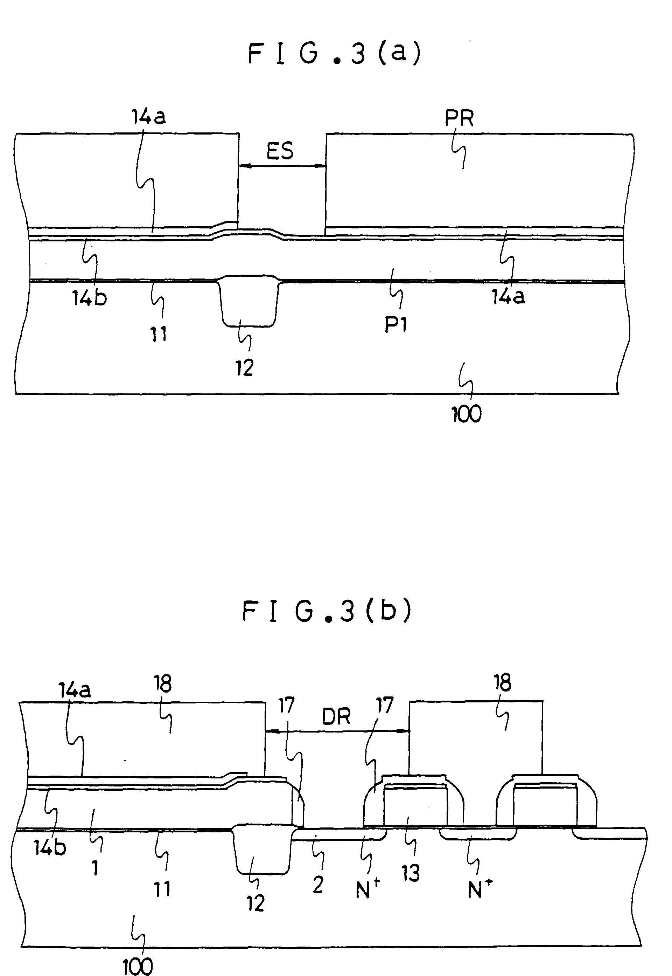

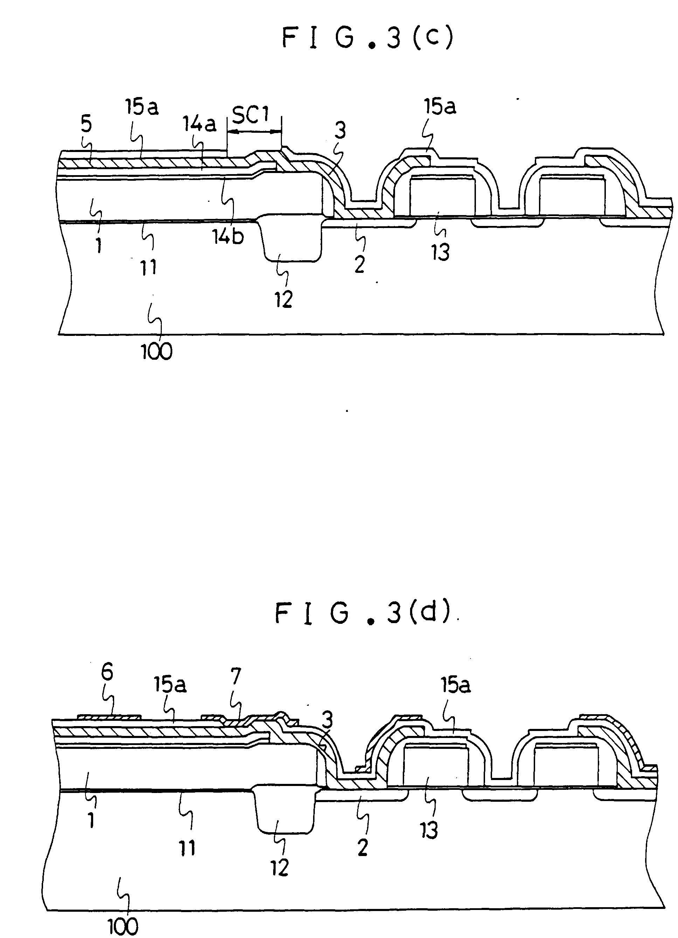

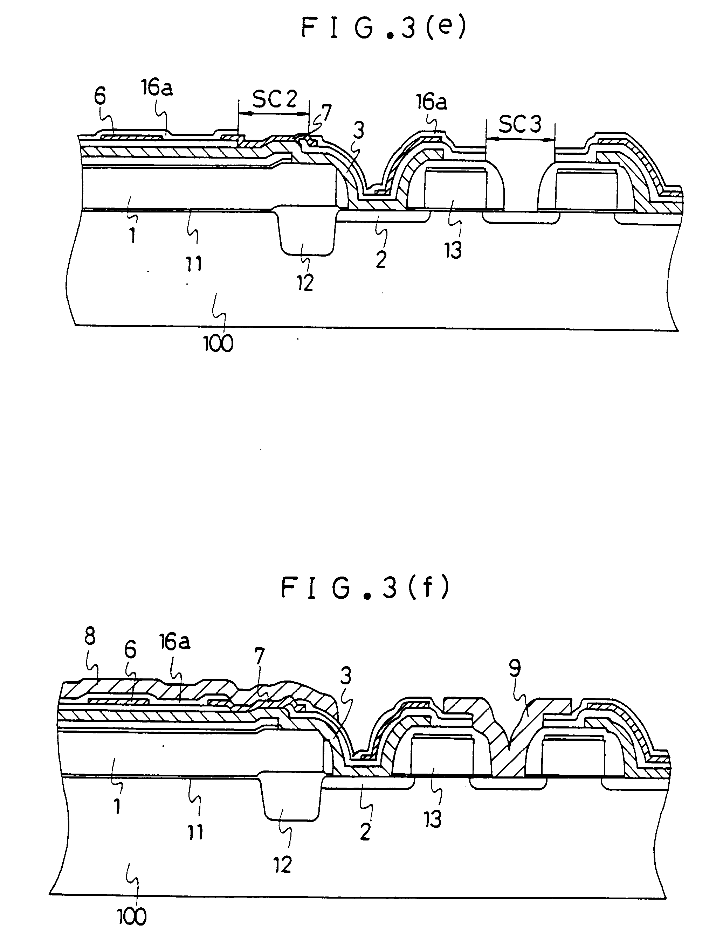

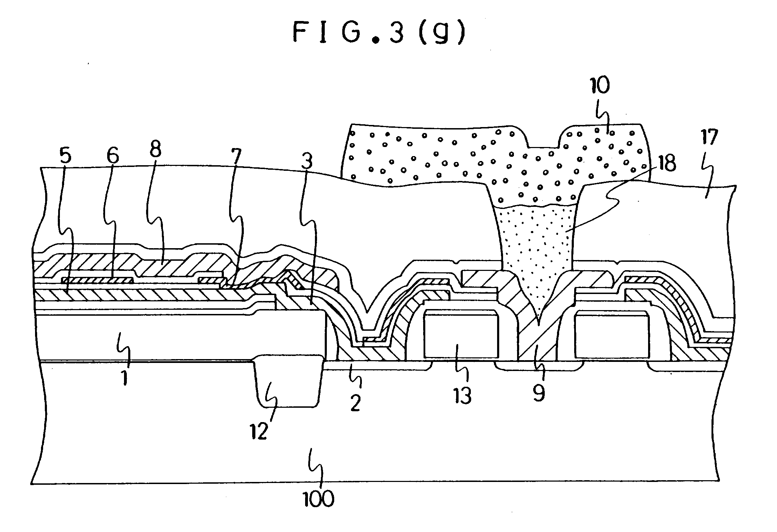

There will be described manufacturing steps according to the embodiment with reference to Fig. 3.

In succession to MOS technical processing, an active region and the element isolation region 12 are first formed on the semiconductor substrate 100. Then, the gate oxide film (SiO$_2$) 11 is thermally grown on the active region. A first polysilicon layer P1 is deposited and doped on the gate oxide film 11 in order to form the gate electrode of the bulk transistor. Sequentially deposited on the first polysilicon layer P1 are an oxidation interrupting layer 14b such as LPCVD-SiN and an insulating CVD oxide film 14a comprising NSG. Photoresist PR is applied on the insulating CVD oxide film 14a to be exposed by a predetermined mask. A connection window ES is provided on the insulating CVD oxide film 14a. On the other hand, the oxidation interrupting layer 14b should not be removed during etching because it prevents the polysilicon layer P1 from being oxidized [Fig. 3 (a)].

As shown in Fig. 3 (b), the first polysilicon layer P1 is patterned by photolithographic and etching steps so that gate electrodes 1 and 13 are formed [Fig. 2 (a)]. Then, ion implantation is carried out in order to form an LDD structure by using the gate electrodes 1 and 13 as masks. More specifically, side walls 17 are formed on the gate electrodes 1 and 13 by using a CVD oxide film. The source and drain region 2 is then formed by ion implantation. In consideration of the strap connection, the residual thin oxide film on the source and drain regions is removed by a new mask 18 having an opening DR.

After the mask 18 is removed, a portion of the oxidation interrupting layer 14b on the gate electrode 1 is etched off. Then, polycide is deposited and patterned in order to form the first and second conductive strap layers. Consequently, there is formed the first conductive strap layer 3 (second conductive strap layer 3') which connects the gate electrode 1 with the drain region 2 [Fig. 2 (b)]. The conductive strap layer may be formed of a metal such as WSi or TiSi. A CVD oxide film layer 15a is deposited as a lower gate insulating layer of the thin film transistor Tr5 over the whole surface so that a connection window SC1 for the connection pad 7 is provided [Fig. 3 (c)].

Then, a third polysilicon layer is deposited and patterned on the CVD oxide film layer 15a in order to form the thin film transistor body [Fig. 2 (c)]. Consequently, the thin film transistor body 6 and the connection pad 7 are formed [Fig. 3 (d)].

As shown in Fig. 3 (e), a second CVD oxide film layer 16a is deposited as the upper gate insulating layer of the thin film transistor. A second connection window SC2 is provided on the connection pad 7. In addition, a connection window SC3 for the connection pad 9 is provided on the source region of the third bulk transistor Tr3.

As shown in Fig. 3 (f), a fourth polysilicon layer is deposited and patterned on the second CVD oxide film layer 16a in order to form the upper gate electrode 8 and connection pad 9 of the thin film transistor. Then, boron ions are implanted in the thin film transistor body 6 by using the upper gate electrode 8 as a self-aligning mask. Consequently, the source and drain regions of the thin film transistor are formed.

As shown in Fig. 3 (g), NSG and BPSG are continuously deposited over the whole surface of a cell, and then flattened by a reflow method. Consequently, an insulating film 17 is formed. Thereafter, the insulating film on the connection pad 9 is removed by etching. A tungsten (w) plug 18 is embedded and a metal 10 is then deposited. Consequently, a metallic interconnection layer is formed.

According to the present invention, the gate electrodes of the first and second bulk transistors are self-aligned with the source or drain region of the third and fourth bulk transistors through the first and second conductive strap layers, respectively. Consequently, a memory cell area can be reduced.

After the gate electrodes of the bulk transistors are patterned, the self-aligning is carried out. Accordingly, the gate oxide film is not deteriorated.

In the case where the thin film transistor is the load of the flip-flop, the conductive strap layer is additionally used as (i) the thin film transistor bottom gate electrode and (ii) contact pad for stacked contacts in the thin film transistor. Consequently, a process can be simplified.

Furthermore, gate electrodes of bulk transistors can be of simple and rectangular shape, which results in easier and more precise photoetching patterning, and better reproducibility of device characteristics.

According to the above-described cell structure, the gate electrode of the first bulk transistor is self-aligned with the source or drain region of the third bulk transistor by the first conductive strap layer. In addition, the gate electrode of the second bulk transistor is self-aligned with the source or drain region of the fourth bulk transistor by the second conductive strap layer. Consequently, there can be reduced an area which is required to connect the gate electrode with the source or drain region (diffusion region). Thus, the cell size can be reduced.

The invention may be embodied in other specific forms and manners without departing from its scope as defined by the claims.

## Claims

1. A method of fabricating static RAM cell comprising first and second bulk transistors (Tr1,Tr2) having gate electrodes (1,1') which extend over an element isolation region (12,12') and forming a flip-flop, and third and fourth bulk transistors (Tr3,Tr4) having source and drain regions (2,2') and formed adjacently to the element isolation region (12,12'), the method comprising:

   forming said gate electrodes (1,1') by depositing and patterning a layer (P1) and forming said source or drain regions (2,2') such that the gate electrode of a respective one of said first and second transistors is self-aligned with the source or drain region of a respective one of said third and fourth transistors, by using the gate electrode as a mask for ion implantation in forming the source or drain region; and forming a respective conductive strap (3,3') which connects each gate electrode to the associated source or drain region;

   characterised in that said layer (P1) from which said gate electrode (1,1') is to be formed is covered, prior to patterning of the gate electrode, with an oxidation prevention layer (14b) which prevents oxidation of said layer (P1), and a portion of the oxidation prevention layer (14b) is removed by etching after patterning of the gate electrode (1,1') and before formation of said conductive strap (3,3') to provide a contact region for the conductive strap to the gate electrode.

2. A static RAM cell having a first pair of transistors (Tr1,Tr2) forming a flip-flop and a second pair of transistors (Tr3,Tr4) for accessing the cell, said transistors (Tr1-Tr4) being formed as bulk elements on a semiconductor substrate (100) by MOS technology, wherein the gate electrode (1,1') of each of said first pair of transistors extends over an element isolation region (12,12') of said substrate and is connected to the source or drain region (2,2') of a respective one of said second pair of transistors, formed adjacently to said element isolation region (12,12'), by a respective one of a pair of conductive straps (3,3'), said gate electrode (1,1') is self-aligned with the associated source or drain region (2,2'), characterised in that said gate electrode (1,1') is covered by an oxidation prevention layer (14b) having a portion removed in a region of contact between the gate electrode (1,1') and the associated conductive strap (3,3').

3. A static RAM cell according to claim 2, wherein each of said conductive straps (3,3') is formed by polysilicon, or polycide which is obtained by laminating silicide on polysilicon.

4. A static RAM cell according to claim 2 or claim 3, wherein each of said transistors (Tr1-Tr4) has a gate electrode (1,1',13) formed of polysilicon.

5. A static RAM cell according to any of claims 2 to 4, wherein each of said conductive straps (3,3') forms the gate electrode (5,5') of a respective one of a third pair of transistors (Tr5,Tr5') providing load elements of the flip-flop.

6. A static RAM cell according to any of claims 2 to 5, wherein said oxidation prevention layer (14b) is SiN.

**Patentansprüche**

1. Verfahren zum Herstellen einer statischen RAM-Zelle mit einem ersten und einem zweiten Volumentransistor (Tr1, Tr2) mit Gateelektroden (1, 1'), die sich über einen Elementisolierbereich (12, 12') erstrecken und ein Flipflop bilden, und mit einem dritten und vierten Volumentransistor (Tr3, Tr4) mit Source- und Drainbereichen (2, 2'), die benachbart zum Elementisolierbereich (12, 12') ausgebildet sind, mit den folgenden Schritten:

- Herstellen der Gateelektroden (1, 1') durch Abscheiden und Mustern einer Schicht (P1), und Herstellen der Source-oder Drainbereiche (2, 2') in solcher Weise, dass die Gateelektrode des jeweiligen Transistors unter dem ersten und zweiten Transistor mit dem Source- oder Drainbereich des jeweiligen Transistors unter dem dritten und vierten Transistor selbstausgerichtet wird, wobei beim Herstellen des Source- oder Drainbereichs die Gateelektrode als Maske bei der Ionenimplantation verwendet wird; und
- Herstellen eines jeweiligen leitenden Anschlussbügels (3, 3'), der jede Gateelektrode mit dem zugehörigen Source-oder Drainbereich verbindet;

**dadurch gekennzeichnet, dass** die Schicht (P1), aus der die Gateelektrode (1, 1') herzustellen ist, vor dem Mustern der Gateelektrode mit einer Oxidationsverhinderungsschicht (14b) überzogen wird, die Oxidation dieser Schicht (P1) verhindert, und ein Teil der Oxidationsverhinderungsschicht (14b) nach dem Mustern der Gateelektrode (1, 1') und vor der Herstellung des leitenden Anschlussbügels (3, 3') durch Ätzen entfernt wird, um einen Kontaktbereich für den leitenden Anschlussbügel zur Gateelektrode zu erzeugen.

2. Statische RAM-Zelle mit einem ersten Paar Transistoren (Tr1, Tr2), die ein Flipflop bilden, und einem zweiten Paar Transistoren (Tr3, Tr4) zum Zugreifen auf die Zelle, wobei diese Transistoren (Tr1-Tr4) durch MOS-Technologie als Volumenelemente auf einem Halbleitersubstrat (100) hergestellt werden und wobei sich die Gateelektrode (1, 1') jedes Transistors des ersten Paars Transistoren über einen Elementisolierbereich (12, 12') des Substrats erstreckt und mit dem Source- oder Drainbereich (2, 2') eines jeweiligen Transistors im zweiten Paar Transistoren, wie benachbart zum Elementisolierbereich (12, 12') ausgebildet, durch einen jeweiligen Anschlussbügel des Paars leitender Anschlussbügel (3, 3') verbunden ist, wobei die Gateelektrode (1, 1') mit dem zugehörigen Source- oder Drainbereich (2, 2') selbstausgerichtet ist, **dadurch gekennzeichnet, dass** diese Gateelektrode (1, 1') durch eine Oxidationsverhinderungsschicht (14b) bedeckt ist, die einen Abschnitt aufweist, der im Kontaktbereich zwischen der Gateelektrode (1, 1') und dem zugehörigen leitenden Anschlussbügel (3, 3') entfernt ist.

3. Statische RAM-Zelle nach Anspruch 2, bei der jeder leitende Anschlussbügel (3, 3') aus Polysilicium oder Polycid besteht, das durch Auflaminieren eines Silicids aus Polysilicium erhalten wurde.

4. Statische RAM-Zelle nach Anspruch 2 oder Anspruch 3, bei der jeder der Transistoren (Tr1-Tr4) eine aus Polysilicium bestehende Gateelektrode (1, 1', 13) aufweist.

5. Statische RAM-Zelle nach einem der Ansprüche 2 bis 4, bei der jeder der leitenden Anschlussbügel (3, 3') die Gateelektrode (5, 5') eines jeweiligen Transistors eines dritten Paars Transistoren (Tr5, Tr5') bildet, die Lastelemente des Flipflops bilden.

6. Statische RAM-Zelle nach einem der Ansprüche 2 bis 5, bei der die Oxidationsverhinderungsschicht (14b) aus SiN besteht.

**Revendications**

1. Procédé pour fabriquer une cellule de mémoire RAM statique comprenant des premier et second transistors de masse (Tr1, Tr2) possédant des électrodes de grille (1,1') qui s'étendent au-dessus d'une région (12,12') d'isolation des éléments, et formant une bascule bistable, et des troisième et quatrième transistors de masse (Tr3, Tr4), comportant des régions de source et de drain (2,2') et formés en position adjacente à la région (12,12') d'isolation des éléments, le procédé consistant à :

former lesdites électrodes de grille (1,1') par dépôt et structuration d'une couche (P1) et former lesdites régions de source et de drain (2,2') de telle sorte que l'électrode de grille de l'un respectif desdits transistors est auto-alignée avec la région de source ou de drain de l'un respectif desdits troisième et quatrième transistors, moyennant l'utilisation de l'électrode de grille en tant que masque pour l'implantation d'ions lors de la formation de la région de source ou de drain;
former une bande conductrice respective (3,3'), qui raccorde chaque électrode de grille à la région de source ou de drain associée;

caractérisé en ce qu'avant la structuration de l'électrode de grille, on recouvre ladite couche (P1), à partir de laquelle ladite électrode de grille (1,1') doit être formée, avec une couche (14b) empêchant l'oxydation, qui empêche une oxydation de ladite couche (P1), et on élimine une partie de la couche (14b) empêchant l'oxydation, par corrosion après structuration de l'électrode de grille (1,1') et avant la formation de ladite bande conductrice (3,3') de manière à former une région de contact de la bande conductrice avec l'électrode de grille.

2. Cellule de mémoire RAM statique comportant un premier couple de transistors (Tr1, Tr2) formant une bascule bistable et un second couple de transistors (Tr3, Tr4) pour l'accès à la cellule, lesdits transistors (Tr1 - Tr4) étant réalisés sous la forme d'éléments de masse sur un substrat semiconducteur (100) au moyen d'une technologie MOS, l'électrode de grille (1,1') de chaque transistor dudit premier couple de transistors s'étendant au-dessus d'une région (12,12') d'isolation des éléments, que comporte ledit substrat, et étant connectée à la région de source ou de drain (2,2') d'un transistor respectif parmi ledit second couple de transistors, formés en position adjacente à ladite région (12,12') d'isolation des éléments, par une bande respective parmi un couple de bandes conductrices (3,3'), ladite électrode de grille (1,1') est auto-alignée avec la région de source ou de drain associée (2,2'), caractérisée en ce que ladite électrode de grille (1,1') est recouverte par une couche (14b) empêchant l'oxydation, dont une partie est retirée dans une région de contact entre l'électrode de grille (1,1') et la bande conductrice associée (3,3').

3. Cellule de mémoire RAM statique selon la revendication 2, dans laquelle chacune desdites bandes conductrices (3,3') est formée de polysilicium ou d'un polycide, qui est obtenu par superposition de siliciure sur du polysilicium.

4. Cellule de mémoire RAM statique selon la revendication 2 ou 3, dans laquelle chacun desdits transistors (Tr1 - Tr4) possède une électrode de grille (1,1', 13) formée de polysilicium.

5. Cellule de mémoire RAM statique selon l'une quelconque des revendications 2 à 4, dans laquelle chacune desdites bandes conductrices (3,3') forme l'électrode de grille (5,5') d'un transistor respectif faisant partie d'un troisième couple de transistors (Tr5, Tr5') constituant des éléments de charge de la bascule bistable.

6. Cellule de mémoire RAM statique selon l'une quelconque des revendications 2 à 5, dans laquelle ladite couche (14b) empêchant l'oxydation est formée de SiN.

# FIG.1

EP 0 465 170 B1

FIG. 2 (a)

FIG. 2 (b)

FIG. 2 (c)

FIG. 2 (d)

EP 0 465 170 B1

# F I G . 3 ( a )

# F I G . 3 ( b )

# F I G . 3 (c)

# F I G . 3 (d).

# FIG.3(e)

# FIG.3(f)

# FIG.3(g)

EP 0 465 170 B1

FIG. 4 (PRIOR ART)

FIG. 5 (PRIOR ART)

FIG. 6 (a)(PRIOR ART)

FIG. 6 (b)(PRIOR ART)